# EUROPEAN PATENT APPLICATION

(11) **EP 4 701 167 A1**
(43) Date of publication of application: **25.02.2026**
(21) Application number: 24864173.0
(22) Date of filing: 20.06.2024
(51) Int. Cl.: H04M 1/02

(54) **FOLDABLE ELECTRONIC DEVICE**

(30) Priority: 14.09.2023 CN 202322515857 U
(71) Applicant: Huawei Technologies Co., Ltd., Shenzhen, Guangdong 518129 (CN)
(72) Inventor: YU, Weidong, Shenzhen, Guangdong 518129 (CN); MAO, Weihua, Shenzhen, Guangdong 518129 (CN); LV, Ren, Shenzhen, Guangdong 518129 (CN)
(74) Representative: Pfenning, Meinig & Partner mbB
(86) International application number: PCT/CN2024/100424
(87) International publication number: WO 2025/055448

(57) **Abstract**

Embodiments of this application provide a foldable electronic device, and relate to the technical field of display electronic products. The foldable electronic device is provided to reduce a risk of a display failure due to compression or impact when the foldable electronic device drops. The foldable electronic device includes a hinge structure, a first middle frame, and a second middle frame. An end portion of the hinge structure includes a blocking member, and along an axial direction of the hinge structure, the blocking member includes a first side surface and a second side surface that face away from each other. The first side surface faces the display, and the second side surface faces away from the display. A partial region on the first side surface has an avoidance space, and along the axial direction of the hinge structure, a projection of the display on the first side surface is at least partially located in the avoidance space. The avoidance space may be used to accommodate the display that is offset toward the blocking member. For example, when the foldable electronic device in a folded state drops with the blocking member impacting the ground, the avoidance space may be used to increase a drop space of the display, reduce a probability that the display impacts the blocking member, and improve drop reliability of the device.

## Description

This application claims priority to Chinese Patent Application No. 202322515857.4, filed with the China National Intellectual Property Administration on September 14, 2023 and entitled "FOLDABLE ELECTRONIC DEVICE", which is incorporated herein by reference in its entirety.

### TECHNICAL FIELD

This application relates to the field of technologies for display electronic products, and in particular, to a foldable electronic device.

### BACKGROUND

Currently, foldable displays are widely applied to electronic devices, such as foldable mobile phones and foldable tablets. In these foldable electronic devices, for example, a dual-fold electronic device, two middle frames are included, and the two middle frames are connected by using a hinge structure, to implement folding and unfolding of the foldable displays.

The foldable electronic devices may drop to the ground during use, and are more vulnerable to damage than non-foldable electronic devices in drop scenarios due to more complex structures. For example, at a position of the hinge structure, it is difficult for drop reliability to meet a drop height requirement of the product. For example, when an electronic device in a folded state drops to the ground, a display swings and impacts an end portion of a hinge structure, which easily causes the foldable display to be compressed, resulting in black spots or line failures.

### SUMMARY

This application provides a foldable electronic device, to alleviate an impact degree of a display when the foldable electronic device drops, and improve drop reliability of the device.

To achieve the foregoing objectives, the following technical solutions are used in embodiments of this application.

According to a first aspect, this application provides a foldable electronic device. For example, the foldable electronic device may be a foldable mobile phone, a foldable tablet, or the like.

The foldable electronic device includes a first middle frame, a second middle frame, a hinge structure, and a display. The first middle frame and the second middle frame are disposed on two sides of the hinge structure, the display is disposed on one side of the hinge structure, the first middle frame, and the second middle frame. The first middle frame and the second middle frame move toward or away from each other through the hinge structure, so that the display is switched between an unfolded state and a folded state. The foldable electronic device may further include more middle frames, to form a dual-fold, triple-fold, or multi-fold electronic device.

An end portion of the hinge structure includes a blocking member, and along an axial direction of the hinge structure, the blocking member includes a first side surface and a second side surface that face away from each other. The display is in the unfolded state or the folded state, the first side surface faces a side surface of the display, and the second side surface faces away from the display. A partial region on the first side surface has an avoidance space, and along the axial direction of the hinge structure, a projection of the display on the first side surface is at least partially located in the avoidance space. The avoidance space may be used to accommodate the display that is offset toward the blocking member. For example, the avoidance space may mean that cavity forming is performed on a part of the first side surface, and a recessed region obtained through cavity forming is used to accommodate the offset display. In some drop scenarios, for example, when the blocking member drops toward the ground, the blocking member may be recessed toward the display due to impact, or the display may swing and drop toward the blocking member. The avoidance space may be used to increase a drop buffer space of the display, or provide a larger space for recession of the blocking member, thereby reducing a risk of a display failure caused by impact between the display and the blocking member.

In a possible implementation, the first side surface of the blocking member has a recess portion that is recessed toward the second side surface, and the avoidance space is located in the recess portion.

In this example of this application, the avoidance space is formed by using the recess portion that is recessed toward the second side surface.

In a possible implementation, the display includes a first part facing the blocking member, and along the axial direction of the hinge structure, a projection of the first part on the first side surface is at least partially located in the recess portion.

In a possible implementation, the display is in the folded state, the first part is in a bent state, and along the axial direction of the hinge structure, a projection of a bent part on the first side surface is at least partially located in the recess portion; or the display is in the unfolded state, the first part is in a flattened state, and along the axial direction of the hinge structure, a projection of a flattened part on the first side surface is at least partially located in the recess portion.

When the foldable electronic device is in the folded state, in a drop scenario, for example, when the blocking member drops toward the ground, the bent part of the display has a great drop amount. The recess portion disposed on the blocking member can accommodate the bent part that drops, so that a display failure caused by impact between the bent part and the blocking member can be avoided.

For example, when the display is in the unfolded state, the display includes the flattened part opposite to the blocking member. When the foldable electronic device is in the unfolded state, for example, when the blocking member drops toward the ground, the recess cavity can accommodate the flattened part of the display, to reduce a probability of impact between the flattened part and the blocking member.

In a possible implementation, along a first direction, in a direction from an edge to a middle of the blocking member, a part that is on the first side surface of the blocking member and that is close to a bottom of the blocking member is inclined toward the second side surface; and the first direction is a direction from the hinge structure to the first middle frame when the display is in the unfolded state.

In this implementation structure, it may be understood that from the edge to the middle of the blocking member, the bottom of the blocking member changes from thick to thin. For example, when the display is in the folded state, in a drop scenario, for example, when the blocking member drops toward the ground, a thick edge of the blocking member can provide reinforcement, to reduce an offset of the blocking member toward the display, thereby reducing a risk of a display failure caused by impact between the display and the blocking member.

In addition, the thick edge of the blocking member can further improve strength of the entire blocking member.

In a possible implementation, a protruding block protruding toward the display is disposed on the first side surface of the blocking member and at a position close to a middle of a top of the blocking member, there is a distance between the protruding block and the bottom of the blocking member, and a part that is of the first side surface and that is recessed relative to the protruding block forms the recess portion.

In this example of this application, the recess portion is formed on the first side surface by using the protruding block formed on the first side surface of the blocking member.

In a possible implementation, the display is in the unfolded state or the folded state, and there is a gap between the side surface of the display and a side surface that is of the protruding block and that faces the display.

In a possible implementation, the recess portion includes a first region located on one side of the protruding block, a second region located on the other side of the protruding block, and a third region located between the protruding block and the bottom of the blocking member; the display is in the folded state, and the display includes a first curved segment, a second curved segment, and a middle curved segment connected between the first curved segment and the second curved segment; the first region faces the first curved segment, and along the axial direction of the hinge structure, a projection of the first curved segment on the first side surface is at least partially located in the first region; the second region faces the second curved segment, and along the axial direction of the hinge structure, a projection of the second curved segment on the first side surface is at least partially located in the second region; and the third region faces the middle curved segment, and along the axial direction of the hinge structure, a projection of the middle curved segment on the first side surface is at least partially located in the third region.

In this application, a plurality of regions are formed by disposing the protruding block, and different regions may be used to accommodate corresponding curved segments of a plurality of different bent parts.

In a possible implementation, the display is in the unfolded state, the recess portion located below the protruding block faces the side surface of the display, and along the axial direction of the hinge structure, the projection of the display on the first side surface is at least partially located in a recess cavity region below the protruding block.

The recess portion located below the protruding block may be used to accommodate an offset part of the unfolded display.

In a possible implementation, along the first direction, a part that is of the first side surface and that is used to form the recess portion is inclined from a middle to an edge; and the first direction is the direction from the hinge structure to the first middle frame when the display is in the unfolded state.

A position that is on the first side surface and that is close to the edge is designed by using an inclined surface. For example, a distance between the bent part of the display and the first side surface can be further increased, and a drop space of the display can be further increased.

In a possible implementation, the first side surface of the blocking member has a protruding block disposed around an edge, and the protruding block disposed around the edge surrounds the recess portion.

In a possible implementation, the display is in the folded state, and the display includes a first curved segment, a second curved segment, and a middle curved segment connected between the first curved segment and the second curved segment; and along the axial direction of the hinge structure, projections of the first curved segment, the second curved segment, and the middle curved segment on the first side surface are at least partially located in the recess portion.

In this implementation structure, the protruding block is disposed around the recess portion, and the recess portion is used to accommodate the offset bent part.

In a possible implementation, an elastic structure is disposed in the recess portion.

Through use of the elastic structure, impact force between the display and the blocking member can be reduced, and a gap between the blocking member and the display can be reduced, thereby improving precision of the entire device.

In a possible implementation, a material of the elastic structure includes at least one of foam, rubber, and a brush.

In a possible implementation, along the first direction, the first side surface is inclined from the middle to the edge; and the first direction is the direction from the hinge structure to the first middle frame when the display is in the unfolded state.

In this example, the avoidance space is formed by performing chamfering on the edge of the first side surface.

In a possible implementation, a region that is on a top surface of the blocking member and that is close to the edge is an inclined surface, and in a direction from the middle to the edge of the blocking member, the inclined surface is inclined toward a direction of a joint between the blocking member and a main shaft.

Through use of the design of the inclined surface, when the electronic device in the folded state drops, a buffer space toward the blocking member can be provided for the bent part of the display.

In a possible implementation, the hinge structure includes the main shaft, the main shaft is located on a side of a non-display surface of the display, an end portion of the main shaft includes the blocking member, the main shaft includes a first surface facing the non-display surface of the display and a second surface facing away from the first surface, and the non-display surface of the display is a surface facing away from a display surface; a region that is of the first surface and that is close to the blocking member is an inclined surface, the inclined surface is inclined toward the second surface in a direction from a middle to the end portion of the main shaft, and there is a gap between the inclined surface and the non-display surface of the display; and in a direction from the display to the main shaft, a projection of the display on the first surface is at least partially located on the inclined surface.

A position that is of the main shaft and that is close to the blocking member is designed as the inclined surface. In this way, a distance between the display and the main shaft can be increased. When the electronic device drops, a large distance can be used to increase a buffer space of the display, thereby reducing a risk of impact between the display and the main shaft.

In a possible implementation, the hinge structure includes the main shaft, the main shaft is located on a side of a non-display surface of the display, an end portion of the main shaft includes the blocking member, the main shaft includes a first surface facing the non-display surface of the display and a second surface facing away from the first surface, and the non-display surface of the display is a surface facing away from a display surface; and a recess cavity is provided in the region that is of the first surface and that is close to the blocking member and at a position close to the middle of the blocking member, and there is a gap between the non-display surface of the display and a bottom surface of the recess cavity.

The design of the recess cavity can be used to provide a larger accommodating space for the display that drops, and protect the display.

In a possible implementation, the display is in the folded state, the display includes a bent part facing the blocking member, and along a thickness direction of the main shaft, a projection of the bent part on the first surface is at least partially located in the recess cavity; or the display is in the unfolded state, the display includes a flattened part facing the blocking member, and along a thickness direction of the main shaft, a projection of the flattened part on the first surface is at least partially located in the recess cavity.

Regardless of whether the display is in the folded state or the unfolded state, when the electronic device drops, the recess cavity can provide a drop space for the display, to protect the display and reduce a risk of impact between the display and the main shaft.

In a possible implementation, a groove is provided on at least one of the first middle frame and the second middle frame and at a position close to the hinge structure, and in a direction from the display to the first middle frame, a projection of the display on the first middle frame is at least partially located in the groove.

For example, in some drop scenarios, when the electronic device in the unfolded state drops, a display located on one side of the hinge structure may bulge upward. The groove can be used to accommodate the bulged display, to reduce a risk of impact between the bulged display and a side frame at an edge of the middle frame.

In a possible implementation, the groove is provided close to the end portion of the hinge structure.

When the electronic device drops, a part that is of the display and that is close to the end portion of the hinge structure has a large deformation amplitude, and therefore the groove is provided close to the end portion of the hinge structure.

In a possible implementation, a first groove is provided at an edge of the first middle frame, and a second groove is provided at an edge of the second middle frame; the blocking member is disposed in a space enclosed by the first groove and the second groove; the edge of the first middle frame has a first surface enclosing the first groove, and the edge of the second middle frame has a second surface enclosing the second groove; and the display is in the folded state, the first surface faces the top surface of the blocking member, there is a gap between the first surface and the top surface of the blocking member, the second surface faces the top surface of the blocking member, and there is a gap between the second surface and the top surface of the blocking member.

In some drop scenarios, for example, when the hinge structure of the electronic device in the folded state drops toward the ground, a drop amount of the middle frame can be reduced by using the gap between the middle frame and the blocking member, to ensure that an accommodating space in which the bent part of the display is located is not compressed.

### BRIEF DESCRIPTION OF DRAWINGS

FIG. 1 is an exploded diagram of a foldable electronic device according to an embodiment of this application;
FIG. 2 is an exploded diagram of a foldable electronic device according to an embodiment of this application;
FIG. 3 is an exploded diagram of a first middle frame and a hinge structure according to an embodiment of this application;
FIG. 4 is a diagram of a structure of a hinge structure according to an embodiment of this application;
FIG. 5 is a diagram of a scenario in which a foldable electronic device drops according to an embodiment of this application;
FIG. 6 is a diagram of a structure of an avoidance structure on a blocking member according to an embodiment of this application;
FIG. 7 is a diagram of a position relationship between a hinge structure and a display according to an embodiment of this application;
FIG. 8 is an enlarged view of A in FIG. 6;
FIG. 9 is a diagram of a position relationship between an avoidance structure on a blocking member and a display in a folded state according to an embodiment of this application;
FIG. 10 is a diagram of a position relationship between a hinge structure and a display in an unfolded state according to an embodiment of this application;
FIG. 11 is a diagram of a structure of an avoidance structure on a blocking member according to an embodiment of this application;
FIG. 12 is a diagram of a position relationship between an avoidance structure on a blocking member and a display in a folded state according to an embodiment of this application;
FIG. 13 is a diagram of a position relationship between an avoidance structure on a blocking member and a display in an unfolded state according to an embodiment of this application;
FIG. 14 is a diagram of a structure of an avoidance structure on a blocking member according to an embodiment of this application;
FIG. 15 is a diagram of a position relationship between an avoidance structure on a blocking member and a display in a folded state according to an embodiment of this application;
FIG. 16 is a diagram of a structure of an avoidance structure on a blocking member according to an embodiment of this application;
FIG. 17 is a diagram of details of the avoidance structure in FIG. 16;
FIG. 18 is a diagram of a position relationship between an avoidance structure on a blocking member and a display in a folded state according to an embodiment of this application;
FIG. 19 is a diagram of a position relationship between an avoidance structure on a blocking member and a display in a folded state according to an embodiment of this application;
FIG. 20 is a diagram of a scenario in which a foldable electronic device drops according to an embodiment of this application;
FIG. 21 is a diagram of a scenario in which a foldable electronic device drops according to an embodiment of this application;
FIG. 22 is a diagram of a position relationship between an avoidance structure on a blocking member and a display in a folded state according to an embodiment of this application;
FIG. 23 is a diagram of a structure of an avoidance structure on a blocking member according to an embodiment of this application;
FIG. 24 is a diagram of a structure of an avoidance structure on a blocking member according to an embodiment of this application;
FIG. 25 is a diagram of a structure of an avoidance structure on a blocking member according to an embodiment of this application;
FIG. 26 is a diagram of a position relationship between an avoidance structure on a blocking member and a display according to an embodiment of this application;
FIG. 27 is a diagram of a position relationship between an avoidance structure on a blocking member and a display in a folded state according to an embodiment of this application;
FIG. 28 is a diagram of a structure of an avoidance structure on a blocking member according to an embodiment of this application;
FIG. 29 is a diagram of a structure of an avoidance structure on a blocking member according to an embodiment of this application;
FIG. 30 is an A-A sectional view of FIG. 29;
FIG. 31 is a B-B sectional view of FIG. 29;
FIG. 32 is an exploded diagram of a first middle frame and a hinge structure according to an embodiment of this application;
FIG. 33 is an enlarged view of B in FIG. 32;
FIG. 34 is an exploded diagram of a first middle frame, a second middle frame, and a hinge structure according to an embodiment of this application;
FIG. 35 is a diagram of a structure of a main shaft and a blocking member according to an embodiment of this application;
FIG. 36 is a diagram of a scenario in which a foldable electronic device drops according to an embodiment of this application;
FIG. 37 is an enlarged view of C in FIG. 36;
FIG. 38 is a diagram of a scenario in which a foldable electronic device drops according to an embodiment of this application;
FIG. 39 is a diagram of a scenario in which a foldable electronic device drops according to an embodiment of this application;
FIG. 40 is an enlarged view of D in FIG. 39;
FIG. 41 is a diagram of a position relationship between a main shaft, a blocking member, and a display according to an embodiment of this application;
FIG. 42 is an enlarged view of E in FIG. 41;
FIG. 43 is a diagram of a structure of an avoidance structure on a blocking member according to an embodiment of this application;
FIG. 44 is a diagram of a position relationship between an avoidance structure on a blocking member and a display in a folded state according to an embodiment of this application;
FIG. 45 is a diagram of a position relationship between an avoidance structure on a blocking member and a display in an unfolded state according to an embodiment of this application;
FIG. 46 is an exploded diagram of a foldable electronic device according to an embodiment of this application;
FIG. 47 is an exploded diagram of a first middle frame, a second middle frame, and a hinge structure according to an embodiment of this application; and
FIG. 48 is a diagram of a structure of a first middle frame according to an embodiment of this application.

### Reference numerals:

100: foldable electronic device;
011: first middle frame; 011A: first middle frame body; 011B: first side frame; 011C: accommodating groove;
012: second middle frame; 012A: second middle frame body; 012B: second side frame;
02: hinge structure; 021: main shaft;
03: display; 031: first non-bent part; 032: second non-bent part; 033: bent part; 033A: first curved segment; 033B: second curved segment; 033C: middle curved segment;
1: blocking member; 11: protruding block; 12: recess portion; 121: first region; 122: second region; 123: third region;
2: elastic structure;
3: decorative frame;
4: groove.

### DESCRIPTION OF EMBODIMENTS

Embodiments of this application provide a foldable electronic device. The foldable electronic device may include various electronic devices having foldable displays and capable of changing an unfolded state or a folded state of the foldable displays and the electronic devices.

Under different use requirements, the foldable electronic device may be unfolded to the unfolded state, or may be folded to the folded state, or may be in an intermediate state between the unfolded state and the folded state.

The foldable electronic device has at least two states, that is, the unfolded state and the folded state. In some cases, the foldable electronic device may further have a third state, that is, the intermediate state between the unfolded state and the folded state. It may be understood that the intermediate state is not a unique state, and may be any one or more states between the unfolded state and the folded state of the foldable electronic device.

For example, the foldable electronic device may include but is not limited to a mobile phone, a tablet computer, a notebook computer, an e-book reader, a camera, a wearable device, a home electronic device, or the like.

For ease of understanding, in embodiments of this application, that the foldable electronic device is a mobile phone is used as an example for description.

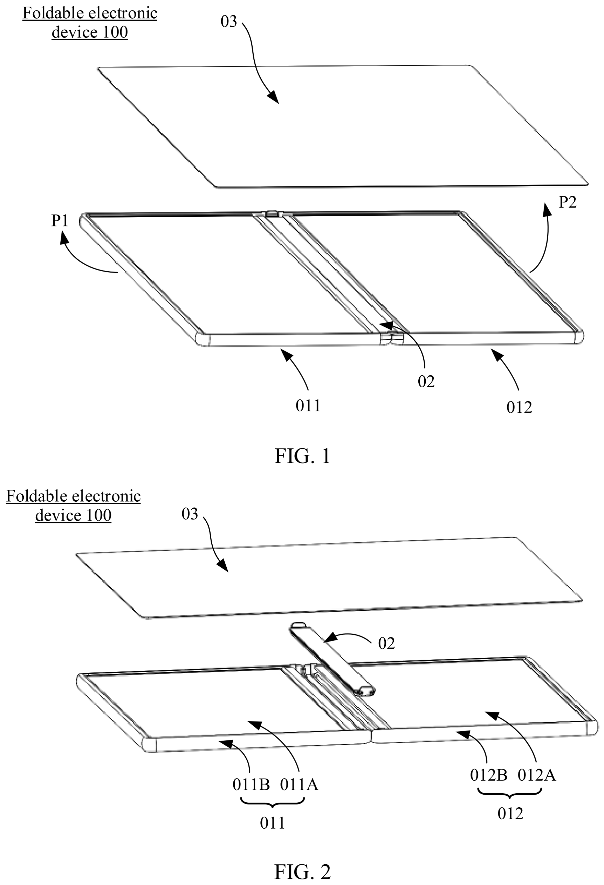

FIG. 1 is an exploded diagram of a foldable electronic device 100 in an unfolded state according to an embodiment of this application. FIG. 2 is a further exploded diagram of the foldable electronic device 100 in the unfolded state according to an embodiment of this application. As shown in FIG. 1 and FIG. 2, the foldable electronic device 100 may include a hinge structure 02, a first middle frame 011, a second middle frame 012, and a display 03.

The first middle frame 011 and the second middle frame 012 are disposed on two opposite sides of the hinge structure 02, and are separately connected to the hinge structure 02. The hinge structure 02 can move, so that the first middle frame 011 and the second middle frame 012 are folded or unfolded relative to each other. When the first middle frame 011 and the second middle frame 012 are folded, the foldable electronic device 100 may be in a folded state. When the first middle frame 011 and the second middle frame 012 are unfolded, the foldable electronic device 100 may be in the unfolded state.

When the foldable electronic device 100 is in the folded state, the display 03 is in the folded state. When the foldable electronic device 100 is in the unfolded state, the display 03 is in the unfolded state.

The display 03 can be configured to: display information and provide an interaction interface for a user. In embodiments of this application, the display 03 may include but is not limited to an organic light-emitting diode (organic light-emitting diode, OLED) display, an active-matrix organic light-emitting diode (active-matrix organic light-emitting diode, AMOLED) display, a mini light-emitting diode (mini organic light-emitting diode) display, a micro light-emitting diode (micro organic light-emitting diode) display, a micro organic light-emitting diode (micro organic light-emitting diode) display, a quantum dot light-emitting diode (quantum dot light-emitting diode, QLED) display, or the like. As described above, the foldable electronic device 100 may switch between the unfolded state and the folded state through moving of the hinge structure 02, and the display 03 may be folded or unfolded with the first middle frame 011 and the second middle frame 012.

For example, a folding manner of the foldable electronic device may include inward folding and outward folding.

The outward folding means that in a process in which the electronic device is switched from the unfolded state to the folded state, and when the electronic device is in the folded state, the display is located on an outer side of the electronic device. In other words, in a folding process and in the folded state, the display 03 is still visible to the user, and in the folded state, the user may further perform some operations on the display 03.

The inward folding means that in a process in which the electronic device is switched from the unfolded state to the folded state, and when the electronic device is in the folded state, the display 03 is located on an inner side of the foldable electronic device 100. In other words, in a folding process, the display 03 is gradually invisible to the user until the display 03 is accommodated between two middle frames and is hidden in the folded state. For example, for the foldable electronic device 100 shown in FIG. 1, when the first middle frame 011 rotates along a direction P1 and the second middle frame 012 rotates along a direction P2, the display 03 is located on the inner side of the foldable electronic device 100, until the display 03 is accommodated between the two middle frames and is hidden in the folded state. In this way, the foldable electronic device 100 may be referred to as an inward-folding electronic device.

Any middle frame provided in embodiments of this application may include a middle frame body and a side frame connected to an outer peripheral edge of the middle frame body. For example, in FIG. 2, the first middle frame 011 includes a first middle frame body 011A and a first side frame 011B connected to an outer peripheral edge of the first middle frame body 011A, and the second middle frame 012 includes a second middle frame body 012A and a second side frame 012B connected to an outer peripheral edge of the second middle frame body 012A.

In some examples, a side that is of the first middle frame 011 and the second middle frame 012 and that is away from the display 03 has a rear cover plate. Either of the first middle frame 011 and the second middle frame 012 may form a mounting space with the rear cover plate, to mount electronic components such as a circuit board, a battery, a receiver, a speaker, and a camera of the foldable electronic device. The circuit board may integrate electronic components such as a main controller, a storage unit, an antenna module, and a power management module of the foldable electronic device. The battery may supply power to electronic components such as the display 03, the circuit board, the receiver, the speaker, and the camera.

In some structures, the first middle frame body 011A and the first side frame 011B in FIG. 2 may be an integrally formed member. Alternatively, in some other structures, the first middle frame body 011A and the first side frame 011B may be mechanical members independent of each other, and during assembly, the first middle frame body 011A may be connected to the first side frame 011B by using a connection structure, for example, an adhesive layer or a connecting member such as a screw.

The second middle frame body 012A and the second side frame 012B of the second middle frame 012 may also be an integrally formed member, or may be two independent mechanical members that need to be connected by using a connecting member.

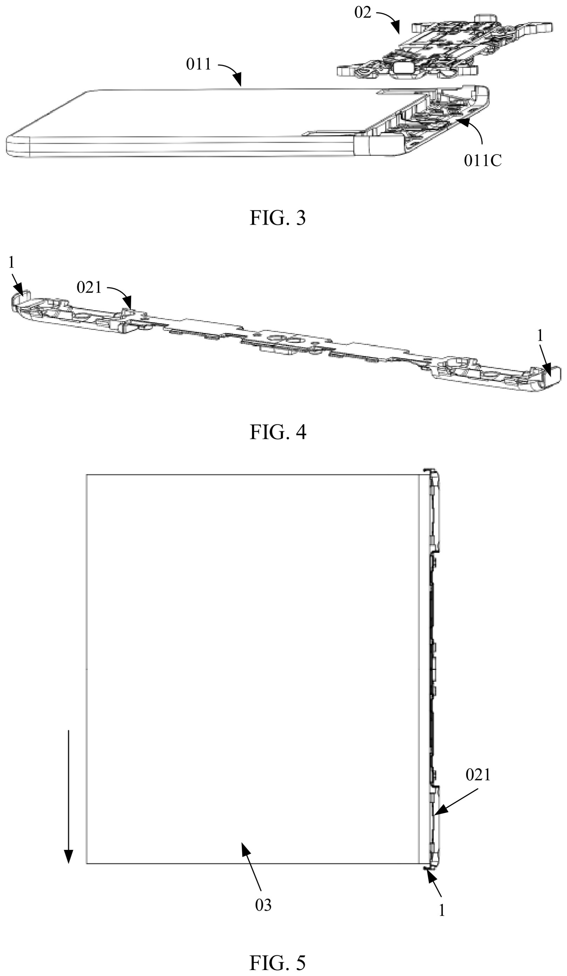

Refer to FIG. 3 and FIG. 4. FIG. 3 is an exploded diagram of the first middle frame 011 and the hinge structure 02. In some examples, the diagram of a structure shown in FIG. 3 may also be a view of the second middle frame 012.

With reference to FIG. 3 and FIG. 4, there is an accommodating groove 011C at a position that is of the first middle frame 011 and that is close to the second middle frame 012. In some structures, there is an accommodating groove at a position that is of the second middle frame 012 and that is close to the first middle frame 011, and the two accommodating grooves may enclose an accommodating space used to dispose the hinge structure 02.

FIG. 4 is a diagram of a structure of the hinge structure 02 according to an embodiment of this application. Along an axial direction of the hinge structure 02, blocking members 1 are separately disposed at two opposite ends of the hinge structure 02.

When the foldable electronic device 100 is in the unfolded state, the hinge structure 02 and the blocking members 1 are at least partially hidden in the accommodating space between the first middle frame 011 and the second middle frame 012.

In some examples, the hinge structure 02 may include a main shaft 021 shown in FIG. 4 and another transmission structure, and the first middle frame 011 and the second middle frame 012 can rotate relative to the main shaft 021 by using some transmission structures. A back cover may be further disposed on a side that is of the main shaft 021 and that is away from the display 03.

As shown in FIG. 4, the blocking member 1 may be disposed at an end portion of the main shaft 021. In some structures, the main shaft 021 and the blocking member 1 may be an integrally formed mechanical member. In this way, a structure of the foldable electronic device can be simplified, and an assembly procedure can be further simplified compared with that of a separately disposed blocking member (which may also be referred to as a T-shaped block), to reduce a phenomenon that a product is defective due to poor assembly.

When foldable electronic devices such as the foldable electronic device in the foregoing example is used, there may be many drop scenarios. For example, as shown in FIG. 5, when the electronic device drops along a direction of a black arrow in FIG. 5, that is, when the blocking member 1 drops toward the ground, regardless of whether the electronic device is in the unfolded state, the folded state, or the intermediate state, the blocking member 1 is recessed toward the display 03 due to impact with the ground, or the display 03 may swing and impact the blocking member 1, and consequently the display 03 may fail.

To avoid a failure of the display due to impact in the drop scenario, embodiments of this application provide some means that can reduce the failure of the display due to impact.

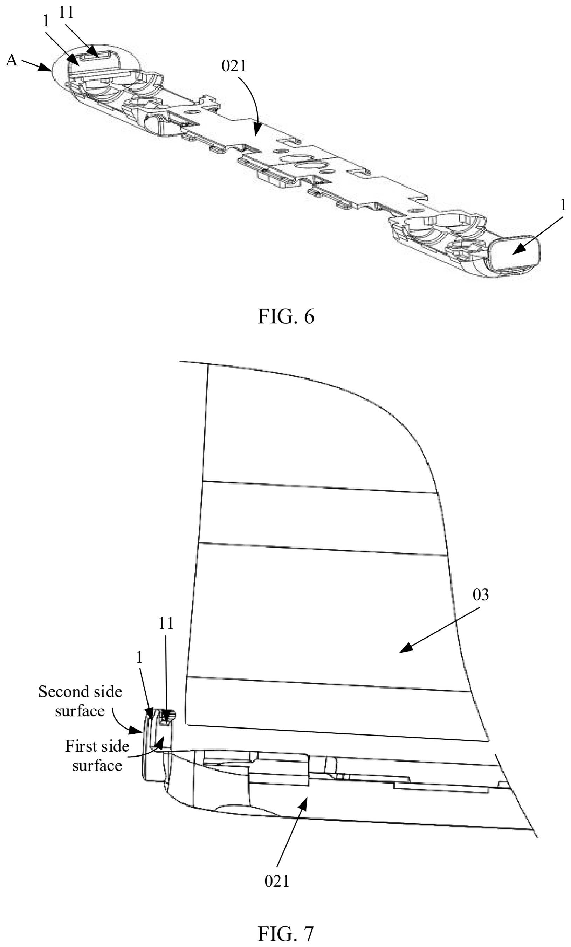

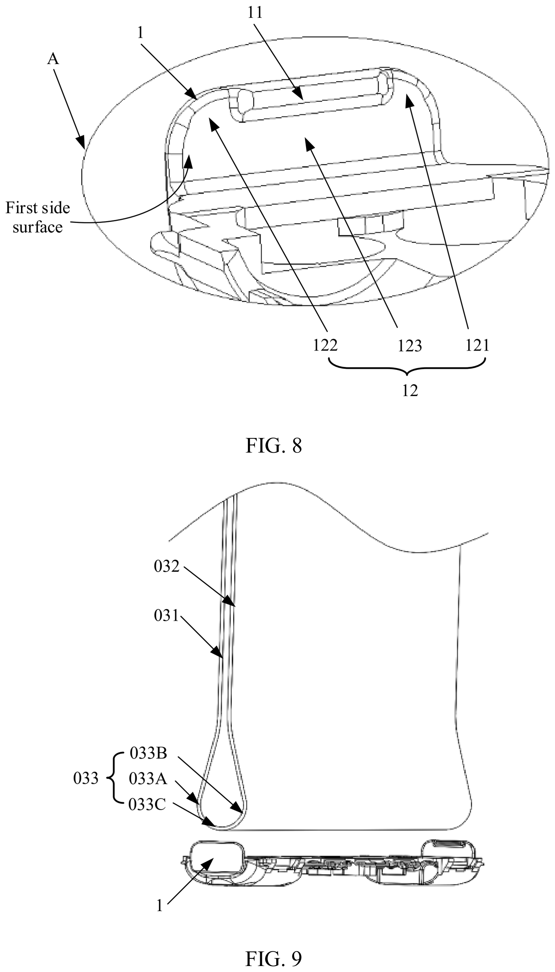

Refer to FIG. 6, FIG. 7, and FIG. 8. FIG. 6 is a diagram of a structure including the main shaft 021 and the blocking member 1 according to an embodiment of this application. FIG. 7 is a diagram of an assembly relationship between the structure shown in FIG. 6 and the display 03. To clearly display a position relationship between the blocking member 1 and the display 03, FIG. 7 shows only a partial structure of the display and the main shaft 021. FIG. 8 is an enlarged view of A in FIG. 6.

As shown in FIG. 6 and FIG. 7, along the axial direction of the hinge structure, the blocking member 1 has a first side surface and a second side surface that face away from each other. When the display 03 is in the folded state, the unfolded state, or the intermediate state, the first side surface faces a side surface of the display 03, and the second side surface faces away from the display 03. A partial region on the first side surface of the blocking member 1 has an avoidance space. Along the axial direction of the hinge structure, a projection of the display on the first side surface is at least partially located in the avoidance space. The avoidance space is used to accommodate the display 03 that is offset toward the blocking member 1.

In this case, when the foldable electronic device 100 drops along the drop direction shown in FIG. 5, the avoidance space can be used to increase a drop space of the display 03, and reduce a risk of impact with the blocking member 1; or increase a space for recession of the impacted blocking member 1, and reduce a probability of impact between the display 03 and the blocking member 1.

This application provides a plurality of implementable avoidance spaces, which are described below.

As shown in FIG. 8, there is a protruding block 11 on the first side surface of the blocking member 1. A region that is of the first side surface and that is recessed relative to the protruding block 11 forms a recess portion 12. The recess portion 12 may be used to accommodate the display 03 that is offset toward the blocking member 1. When the foldable electronic device is in the unfolded state or the folded state, there is a gap between the display and a side surface that is of the protruding block 11 and that faces the display. FIG. 9 is an exploded diagram of the blocking member 1 and the display 03 in the folded state, and shows a partial structure of the display 03. The display 03 in the folded state includes a first part 031, a second part 032, and a third part 033. The third part 033 is connected between the first part 031 and the second part 032.

In some examples, the first part 031 is connected to the first middle frame 011, the second part 032 is connected to the second middle frame 012, and the third part 033 is located on one side of the hinge structure 02. When the first middle frame 011 and the second middle frame 012 rotate toward each other through the hinge structure 02, in some structures, the third part 033 includes a bent part, and the bent part may be in a teardrop-shaped structure shown in FIG. 9.

FIG. 9 shows an example of approximate positions of the first part 031, the second part 032, and the third part 033, and does not constitute an absolute limitation on the positions.

With reference to FIG. 8 and FIG. 9, when the electronic device is in the folded state, the recess portion 12 shown in FIG. 8 faces the third part 033 shown in FIG. 9, and the recess portion 12 may accommodate the third part 033 that is offset toward the blocking member 1.

In some examples, when the display 03 is in the folded state, along the axial direction of the hinge structure, a projection of the third part 033 on the first side surface is at least partially located in the recess portion 12.

When the electronic device in the folded state drops along the direction shown in FIG. 5, the third part 033 shown in FIG. 9 has a greater drop amount than the first part 031 and the second part 032. The recess portion 12 is disposed on the first side surface of the blocking member 1, and the recess portion 12 may be used to increase a distance between the third part 033 and the blocking member 1. In this way, a drop space of the third part 033 can be increased, a risk of impact between the third part 033 and the blocking member 1 can be reduced, and it can be ensured that the display basically does not impact the blocking member to cause a display failure.

As shown in FIG. 8, the protruding block 11 is close to a top of the blocking member 1, and is basically at a middle position. In other words, the recess portion may be formed on two sides of the protruding block 11. There is a gap between the protruding block 11 and a bottom of the blocking member 1, and the bottom of the blocking member 1 may be understood as a joint between the blocking member 1 and the main shaft 201.

In this way, the recess portion 12 shown in FIG. 8 may be divided into: a first region 121 located on one side of the protruding block 11, a second region 122 located on the other side of the protruding block 11, and a third region 123 located between the protruding block 11 and the bottom of the blocking member 1.

Division into the first region 121, the second region 122, and the third region 123 in FIG. 8 is merely an example, and the first region 121, the second region 122, and the third region 123 may be appropriately reduced or increased based on the range.

As shown in FIG. 9, the third part 033 having the teardrop-shaped structure may include a first curved segment 033A connected to the first part 031, a second curved segment 033B connected to the second part 032, and a middle curved segment 033C connected between the first curved segment 033A and the second curved segment 033B.

When the display 033 is in the folded state, with reference to FIG. 8 and FIG. 9, the first region 121 faces at least a part of the first curved segment 033A, and a projection of the first curved segment 033A in a direction to the first side surface is at least partially located in the first region 121; the second region 122 faces at least a part of the second curved segment 033B, and a projection of the second curved segment 033B in the direction to the first side surface is at least partially located in the second region 122; and the third region 123 faces at least a part of the middle curved segment 033C, and a projection of the middle curved segment 033C in the direction to the first side surface is at least partially located in the third region 123.

When the electronic device in the folded state drops, the first region 121 may be used to accommodate at least a part of the first curved segment 033A offset toward the first side surface, the second region 122 may be used to accommodate at least a part of the second curved segment 033B offset toward the first side surface, and the third region 123 may be used to accommodate at least a part of the middle curved segment 033C offset toward the first side surface.

For example, when the electronic device in the folded state drops along the direction shown in FIG. 5, each curved segment of the third part 033 is offset toward a corresponding recess portion region, and different recess portion regions are used to accommodate corresponding curved segments, thereby reducing a possibility that each curved segment is impacted, and improving drop reliability of the entire bent part.

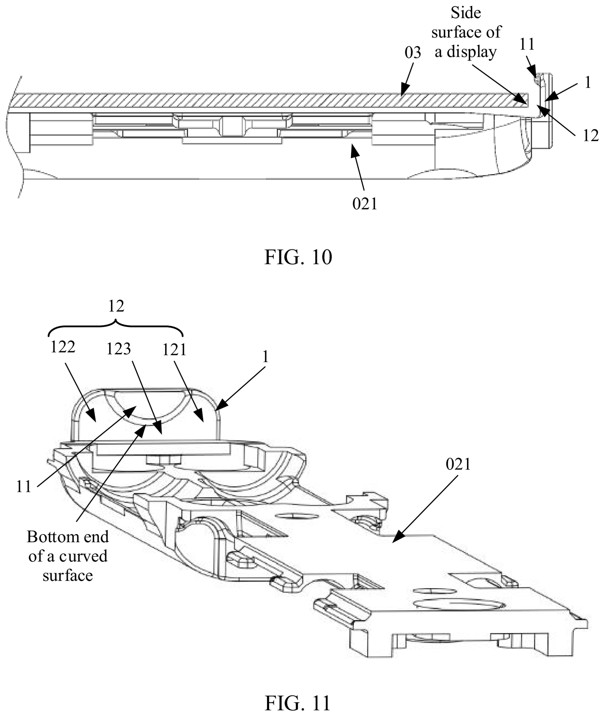

The avoidance recess portion 12 shown in FIG. 8 may be further used to accommodate the display in the unfolded state. For example, FIG. 10 shows an example of a position relationship between the display 03 in the unfolded state and the blocking member 1, and shows a partial structure of the main shaft 021 and the display 03. As shown in FIG. 10, the display 03 is in the unfolded state, the recess portion 12 faces the side surface of the display 03, there is a distance between the side surface of the display 03 and the recess portion 12, and the recess portion 12 is used to accommodate a part of the display 03 in the unfolded state that is offset toward the first side surface. The electronic device is in the unfolded state, and a projection of the display 03 toward the blocking member is located between the protruding block 11 and the main shaft 021.

In some examples, the display is in the unfolded state, the display includes a flattened part located on one side of the hinge structure, and an orthographic projection of the flattened part on the first side surface is located in the recess portion.

When the electronic device in the unfolded state drops along the direction shown in FIG. 5, the flattened part of the display on one side of the hinge structure exhibits significant dropping. The recess portion 12 disposed on the blocking member 1 may be used to increase a drop buffer space of the flattened part on one side of the hinge structure, thereby reducing a risk of impact between the flattened part and the blocking member 1.

As shown in FIG. 8 to FIG. 10, the recess portion 12 formed on the blocking member 1 may be used to accommodate the bent part of the display in the folded state, and may be further used to accommodate a part of the display in the unfolded state.

In the example shown in this application, as shown in FIG. 8 to FIG. 10, the recess portion 12 is formed on the side surface of the blocking member 1 to increase the distance between the display 03 and the blocking member 1, instead of moving the entire blocking member. In this way, the distance between the display 03 and the blocking member 1 is not increased, meeting a high precision requirement for a small gap between the blocking member and the display.

FIG. 11 shows another avoidance structure according to an embodiment of this application. As shown in FIG. 11, a protruding block 11 is disposed on the first side surface that is of the blocking member 1 and that faces the display, and a region that is of the first side surface and that is recessed relative to the protruding block 11 forms a recess portion 12.

With reference to FIG. 8 of the foregoing example and FIG. 11 of this example, a bottom of the protruding block 11 in FIG. 11 is closer to the bottom of the blocking member 1 (the bottom is the joint between the blocking member 1 and the main shaft 021) than a bottom of the protruding block 11 in FIG. 8.

In addition, shapes of the protruding blocks 11 in the two examples are different. In FIG. 11, an outer edge of the protruding block 11 is a curved surface, and along a direction from a bottom end to two sides of the curved surface, a distance between the outer edge of the protruding block 11 and the bottom of the blocking member 1 gradually increases.

The protruding block 11 disposed on the blocking member 1 may also divide the recess portion 12 into a first region 121 located on one side of the protruding block 11, a second region 122 located on the other side of the protruding block 11, and a third region 123 located between the protruding block 11 and the bottom of the blocking member 1.

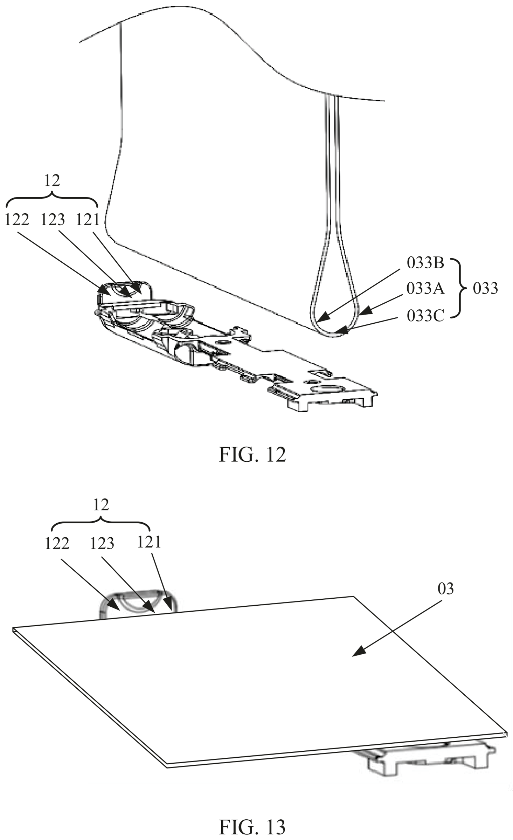

FIG. 12 is an exploded diagram of a position relationship between the blocking member 1 shown in FIG. 11 and the display 03 in the folded state. The third part 033 of the display in the folded state includes a first curved segment 033A, a second curved segment 033B, and a middle curved segment 033C connected between the first curved segment 033A and the second curved segment 033B.

As shown in FIG. 12, the first region 121 faces at least a part of the first curved segment 033A, and a projection of the first curved segment 033A in a direction to the first side surface is at least partially located in the first region 121; the second region 122 faces at least a part of the second curved segment 033B, and a projection of the second curved segment 033B in the direction to the first side surface is at least partially located in the second region 122; and the third region 123 faces at least a part of the middle curved segment 033C, and a projection of the middle curved segment 033C in the direction to the first side surface is at least partially located in the third region 123.

When the electronic device in the folded state drops, the first region 121 may be used to accommodate at least a part of the first curved segment 033A offset toward the first side surface, the second region 122 may be used to accommodate at least a part of the second curved segment 033B offset toward the first side surface, and the third region 123 may be used to accommodate at least a part of the middle curved segment 033C offset toward the first side surface. In some drop scenarios, for example, the drop scenario in FIG. 5, each curved segment of the third part 033 is offset toward a corresponding recess portion region, and different recess portion regions are used to accommodate corresponding curved segments, thereby reducing a possibility that each curved segment is impacted, and improving drop reliability of the entire bent part.

FIG. 13 is an exploded diagram of a position relationship between the blocking member 1 shown in FIG. 11 and the display 03 in the unfolded state. When the display 03 is in the unfolded state, a projection, on the first side surface, of a part that is of the display in the unfolded state and that is opposite to the blocking member 1 is at least partially located in the recess portion 12.

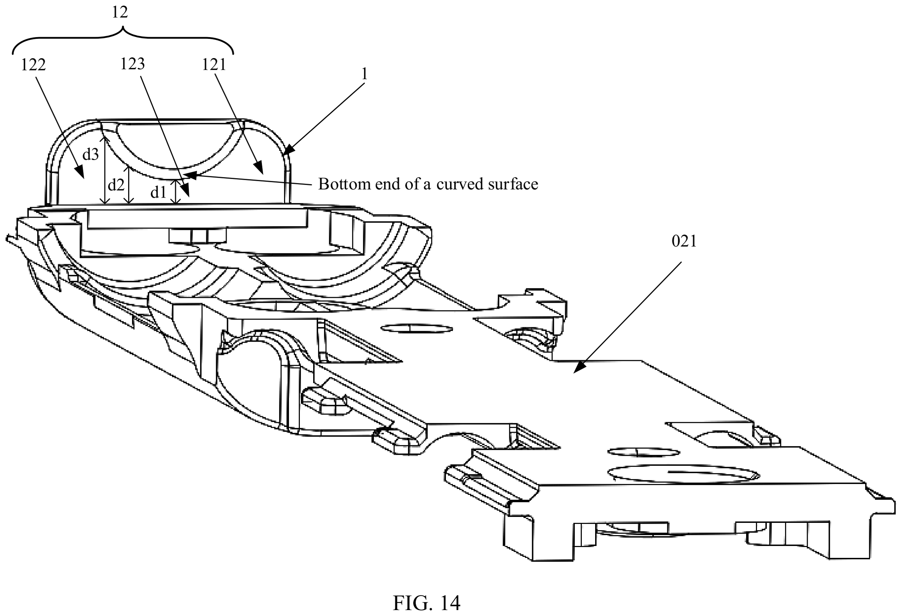

In some embodiments, the projection, on the first side surface, of the part that is of the display in the unfolded state and that is opposite to the blocking member 1 is at least partially located in a recess portion region below the protruding block 11. In addition, as shown in FIG. 14, along the direction from the bottom end to the two sides of the curved surface, the distance between the outer edge of the protruding block 11 and the bottom of the blocking member 1 gradually increases. For example, in FIG. 14, a distance d between the outer edge of the protruding block 11 and the bottom of the blocking member 1 is larger when it is closer to the two sides of the curved surface. For example, d3 is greater than d2, and d2 is greater than d1. In this way, areas of the corresponding first region 121 and second region 122 can be increased, so that the first curved segment 033A and the second curved segment 033B of the display 03 can have a larger accommodating space.

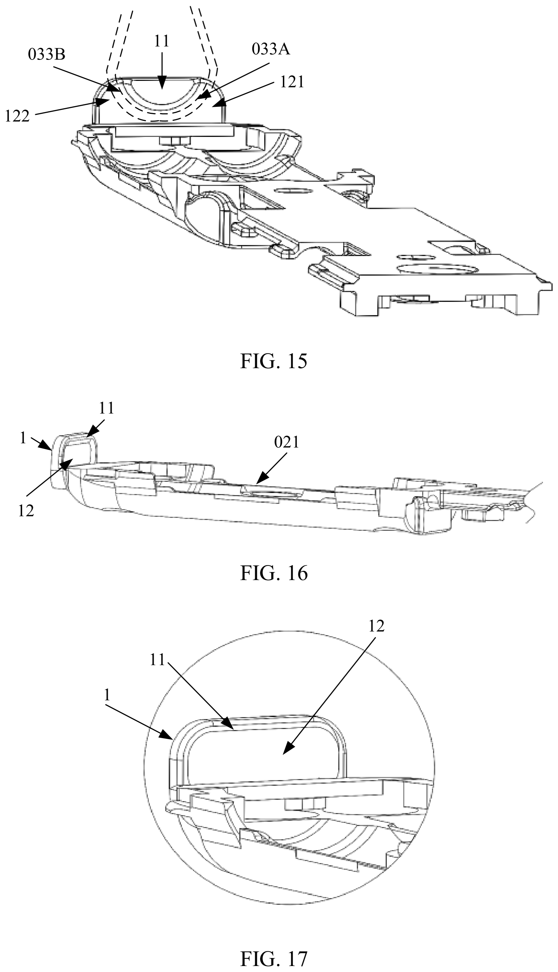

For example, FIG. 15 shows a position relationship between the first region 121, the second region 122, the first curved segment 033A, and the second curved segment 033B when the display is in the folded state. Because the distance between the outer edge of the protruding block 11 and the bottom of the blocking member 1 gradually increases along the direction from the bottom end to the two sides of the curved surface, an outer contour of the first region 121 accommodating the first curved segment 033A is of a curved structure and with a shape matching the first curved segment 033A with a curved structure, and an outer contour of the second region 122 accommodating the second curved segment 033B is also of a curved structure and with a shape matching the second curved segment 033B with a curved structure, so that a probability that the display impacts the protruding block 11 when dropping in the folded state is effectively reduced.

FIG. 16 and FIG. 17 show another avoidance structure according to an embodiment of this application. As shown in FIG. 16 and FIG. 17, FIG. 17 is a detailed diagram of FIG. 16. A protruding block 11 is disposed on the first side surface that is of the blocking member 1 and that faces the display, the protruding block 11 is disposed around an outer edge of the blocking member 1, and the protruding block 11 that is disposed around the outer edge of the blocking member 1 encloses the recess portion 12.

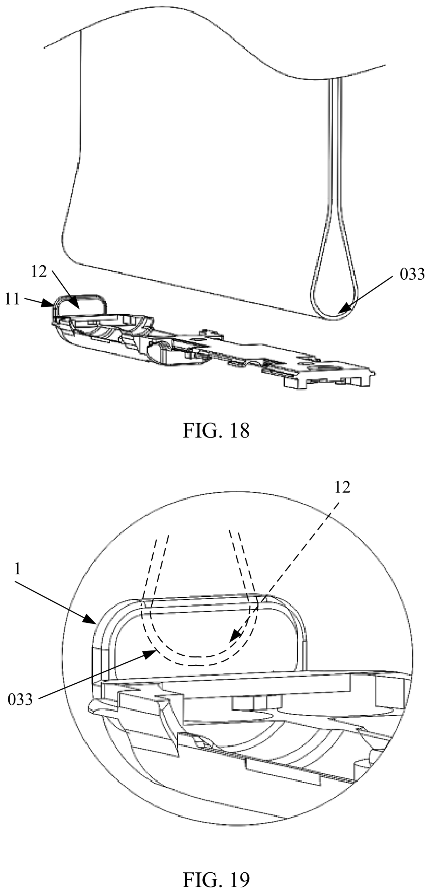

FIG. 18 and FIG. 19 are exploded diagrams of a position relationship between the blocking member 1 shown in FIG. 16 and the display 03 in the folded state. When the display 03 is in the folded state, a projection of the third part 033 on the blocking member 1 is at least partially located in the recess portion 12, and the recess portion is used to accommodate at least a part of the third part 033 offset toward the blocking member.

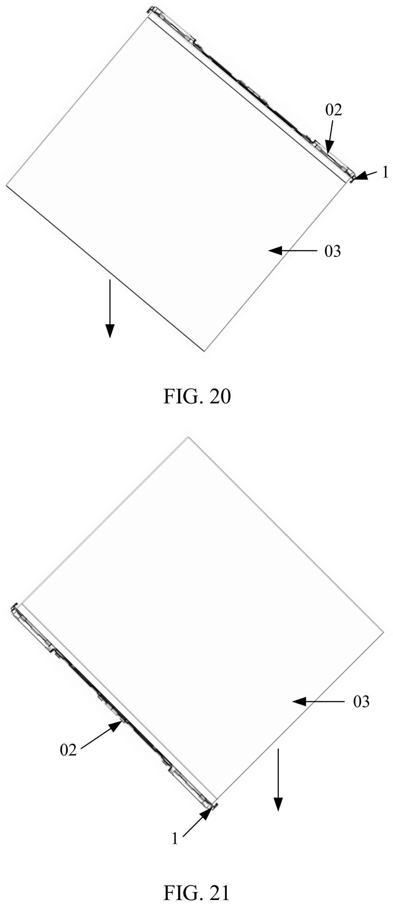

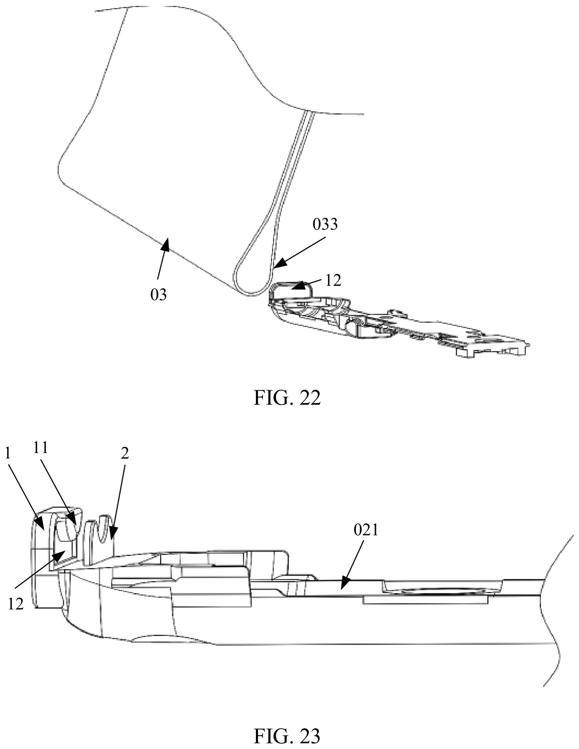

In some drop scenarios, for example, as shown in FIG. 20 and FIG. 21, when the electronic device drops along a direction of a black arrow in FIG. 20, that is, a corner on a side that is of the foldable electronic device and that is far away from the hinge structure 02 impacts the ground, or when the electronic device drops along a direction of a black arrow in FIG. 21, that is, a corner of the foldable electronic device with the hinge structure 02 impacts the ground, as shown in FIG. 22, the display 03 is inclined relative to the hinge structure, so that the large recess portion 12 shown in FIG. 19 that is disposed on the blocking member 1 can provide a larger accommodating space for the inclined bent part 033.

In some implementable structures, as shown in FIG. 23, an elastic structure 2 may be disposed in the recess portion 12 of the blocking member 1. The elastic structure may provide a buffering function, and the elastic structure 2 is disposed on a surface that is of the recess portion 12 and that faces the side surface of the display.

When the display 03 is offset toward the blocking member 1, direct impact between the display 03 and the blocking member 1 with high strength can be avoided by using elasticity and the buffering function of the elastic structure 2, and the display 03 can be protected by using the elastic structure 2.

There are a plurality of materials that may be selected for the elastic structure 2. For example, at least one of foam, rubber, and a brush may be selected.

The elastic structure 2 may be adhered to the recess portion by using an adhesive layer, or may be disposed in the recess portion by using another connection structure.

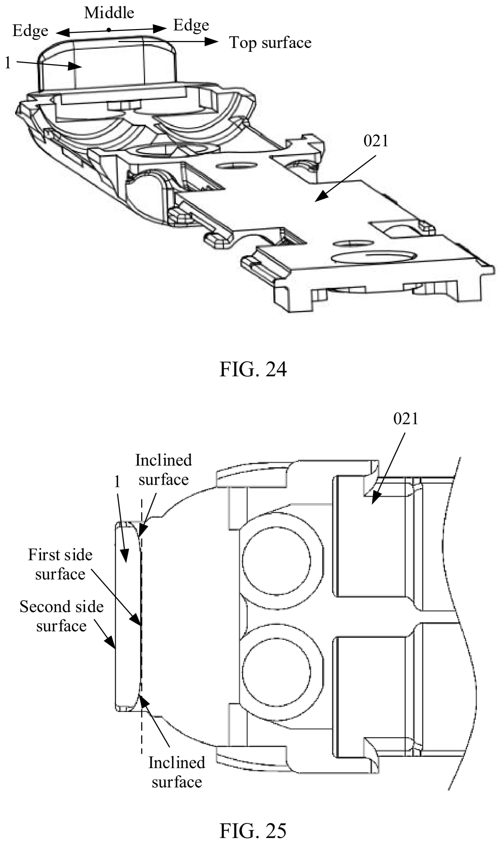

FIG. 24 shows another avoidance structure according to an embodiment of this application. FIG. 25 shows a partial structure of a top view of FIG. 24. As shown in FIG. 24 and FIG. 25, on the first side surface that is of the blocking member 1 and that faces the display, when the display is in the unfolded state, along a direction from the hinge structure to the first middle frame, the first side surface is inclined toward the second side surface (an inclined surface shown in FIG. 25) in a direction from the middle to the edge of the blocking member 1. In some implementations, a thickness of the middle of the blocking member 1 is greater than a thickness of the edge of the blocking member 1, or a distance between the middle of the blocking member 1 and the side surface of the display is less than a distance between the edge of the blocking member 1 and the side surface of the display, and the edge of the blocking member 1 is farther away from the side surface of the display than the middle. For example, when the display 03 is in the folded state, a larger drop space can be provided for the bent part of the display.

In FIG. 25, to clearly display the inclined surface, a dashed line in FIG. 25 indicates a position of the first side surface when the first side surface is not inclined.

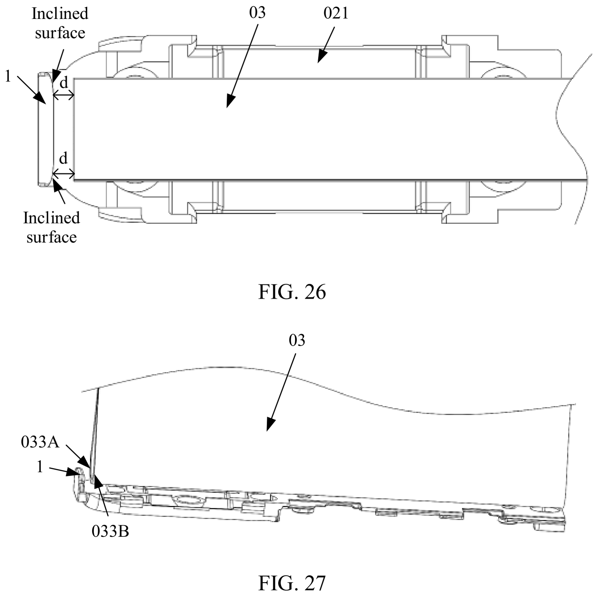

FIG. 26 shows an example of a position relationship between the blocking member 1 and the display 03. Because of the design of the inclined surface that is of the first side surface of the blocking member 1 and that is close to the edge, as shown in FIG. 26, a distance d between the side surface of the display 03 and the blocking member 1 is larger when it is closer to the edge of the blocking member 1.

For example, when the display 03 is in the folded state as shown in FIG. 27, the first curved segment 033A and the second curved segment 033B of the bent part face a corresponding inclined surface. Because there is a large gap between the inclined surface and the curved segment, the curved segment has a large drop buffer space, and a risk of a failure due to impact between the curved segment and the blocking member is reduced.

Return to FIG. 24. A region that is on a top surface of the blocking member 1 and that is close to the edge is an inclined surface, and in the direction from the middle to the edge of the blocking member 1, the inclined surface is inclined toward a direction of the joint between the blocking member 1 and the main shaft 201.

In the example of FIG. 24, the top surface of the blocking member 1 is set as an inclined surface. When the first middle frame and the second middle frame rotate relative to the hinge structure, the inclined surface may be used to provide an avoidance space for the rotating first middle frame and second middle frame, to ensure smooth rotation of the first middle frame and the second middle frame.

In different avoidance structures in the foregoing examples, in some examples, the protruding block is disposed on the first side surface that is of the blocking member 1 and that faces the display, the protruding block is used to form the recess portion on the first side surface, and the recess portion is used to accommodate the offset display. In some other examples, chamfering is performed on the edge of the first side surface to form the inclined surface, and the distance between the display and the blocking member is increased by using the inclined surface to accommodate the offset display.

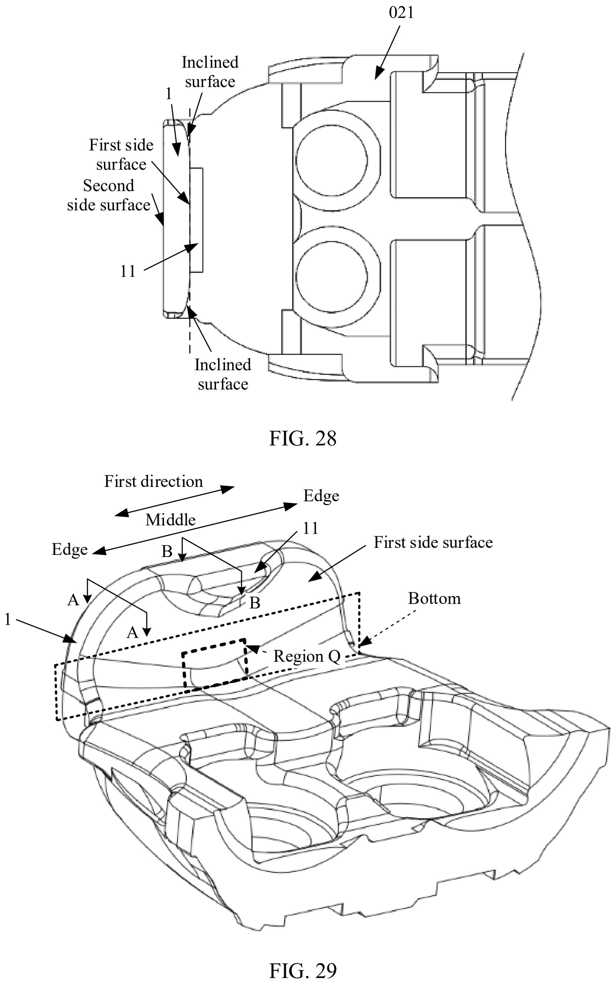

In some other examples, the inclined surface may alternatively be disposed on the blocking member 1 having the protruding block. For example, in FIG. 28, when the first side surface of the blocking member 1 has the protruding block 11, the first side surface may be inclined toward the second side surface in a direction from a middle to the edge of the first side surface to form the inclined surface.

In this way, the distance between the display 03 and the blocking member 1 can be further increased, the drop buffer space of the display can be further increased, and drop reliability of the display can be improved.

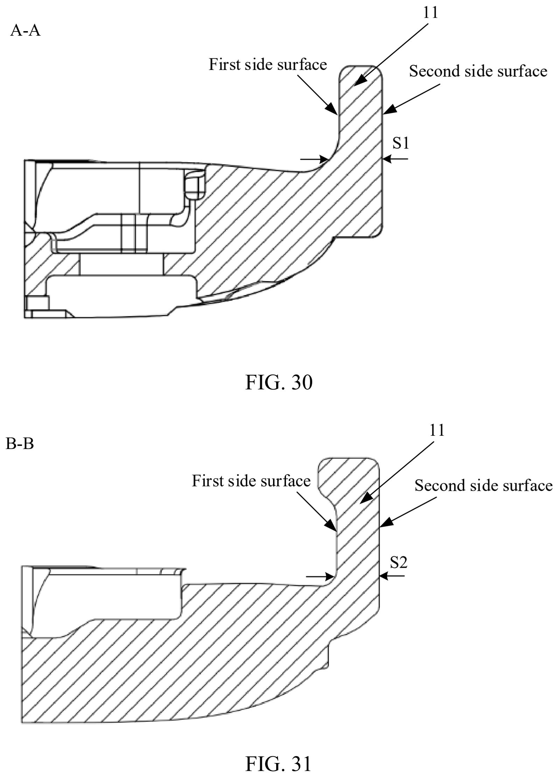

FIG. 29 is a diagram of a structure of another blocking member according to an embodiment of this application. FIG. 30 is a sectional view taken along A-A in FIG. 29, and FIG. 31 is a sectional view taken along B-B in FIG. 29.

As shown in FIG. 29, this example is a structural improvement on the bottom (a position shown in a dashed-line box) of the blocking member 1. Compared with a B-B section line position in FIG. 31, an A-A section line position shown in FIG. 30 is closer to the edge of the blocking member 1. In other words, the B-B section line position in FIG. 31 is closer to the middle of the blocking member 1, and the A-A section line position in FIG. 30 is closer to the edge of the blocking member 1. An A-A section and a B-B section are along a first direction. The first direction in this example may be understood as s direction from the hinge structure to the first middle frame when the display is in the unfolded state.

With reference to FIG. 29, FIG. 30, and FIG. 31, in this example, along the first direction, in a direction from the edge to the middle of the blocking member, a part that is on the first side surface of the blocking member and that is close to the bottom of the blocking member is inclined toward the second side surface.

Alternatively, it may be understood that, as shown in FIG. 30, a distance between the first side surface and the second side surface is S1 at a position that is of the blocking member 1 and that is close to the edge; and as shown in FIG. 31, a distance between the first side surface and the second side surface is S2 at a position that is of the blocking member 1 and that is close to the middle. S1 is greater than S2. In other words, in the first direction, from the edge to the middle of the blocking member, a thickness of a bottom part of the blocking member 1 changes from thick to thin, and the thickness herein is a size between the first side surface and the second side surface.

In some use scenarios, for example, when the display is in the folded state, the blocking member 1 drops toward the ground, and the blocking member 1 is inclined toward the display due to impact. A thick edge of the blocking member 1 can reduce an offset of the blocking member 1 toward the display. In this way, a risk of a display failure caused by impact between the display and the blocking member can be reduced.

In addition, the thick edge of the blocking member 1 can increase mechanical resistance of the entire blocking member, and reduce a risk of the blocking member breaking upon dropping.

In addition, in this example of this application, a structure that changes from thick to thin is located at a bottom position of the blocking member 1, and a region located at the bottom of the blocking member 1 may accommodate the bent display, or may provide accommodating space for the bent display.

As shown in FIG. 29, in this example, there is a protruding block 11 protruding toward the display on the first side surface of the blocking member 1 and at a position close to a middle of a top of the blocking member 1. In some other examples, no protruding block may be disposed on the first side surface of the blocking member 1.

As shown in FIG. 29, the bottom of the blocking member 1 has a region (for example, a region Q in FIG. 29) with a smallest thickness (a size between the first side surface and the second side surface), and the protruding block 11 on the blocking member 1 may be disposed opposite to the region Q with the smallest thickness.

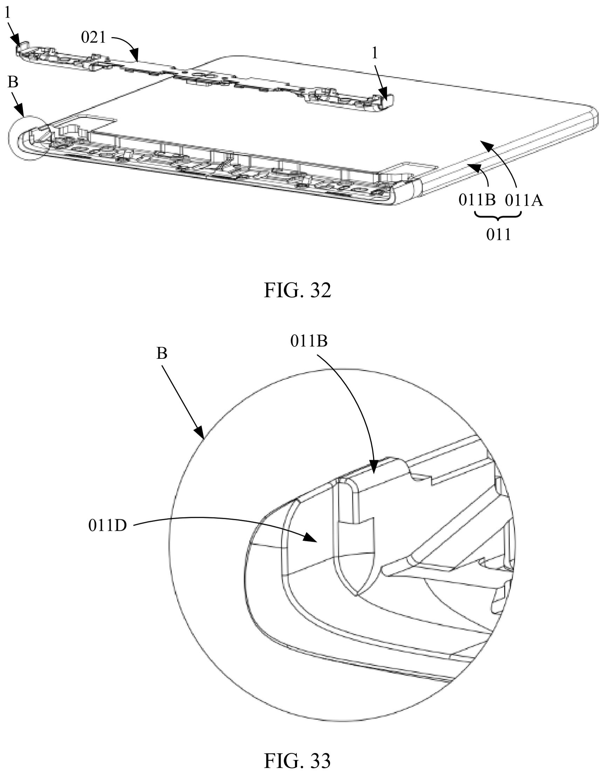

Refer to FIG. 32 and FIG. 33. FIG. 33 is an enlarged view of B in FIG. 32. To accommodate the blocking member 1, a first groove 011D may be provided on a first side frame 011B of the first middle frame 011, and the first groove 011D is configured to accommodate at least a part of the blocking member 1.

In some examples, a second groove may be provided on a second side frame 012B of the second middle frame 012, and the first groove and the second groove may be used together to accommodate the blocking member 1.

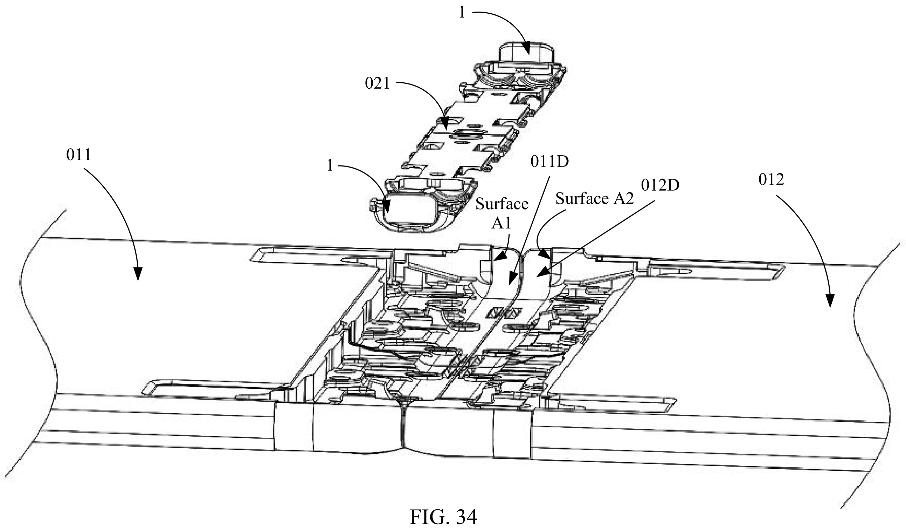

As shown in FIG. 34, the first side frame 011B of the first middle frame 011 has a first surface forming the first groove 011D, and the first surface may be a surface A1 in FIG. 34. The second side frame 012B of the second middle frame 012 has a second surface forming the second groove 012D, and the second surface may be a surface A2 in FIG. 34. When the foldable display terminal 100 is in the unfolded state, the surface A1 faces the surface A2, and at least a part of the blocking member 1 is disposed in space between the surface A1 and the surface A2.

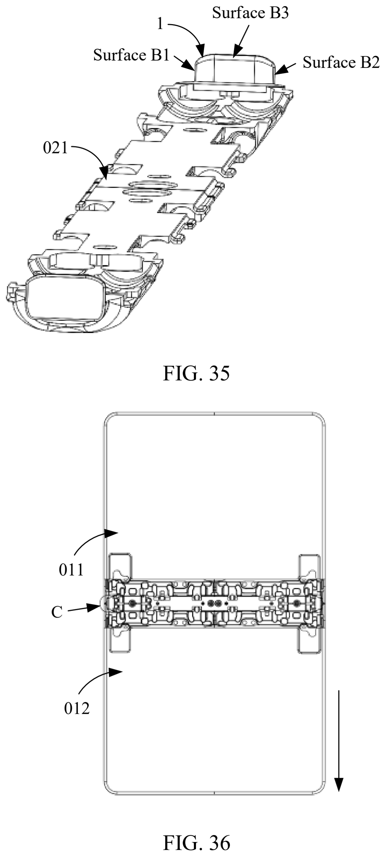

FIG. 35 is a diagram of an example of a structure of the blocking member 1. The blocking member 1 has a surface B1 and a surface B2 that are opposite to each other, and a surface B3 connected between the surface B1 and the surface B2. The surface B3 may also be referred to as a top surface of the blocking member 1.

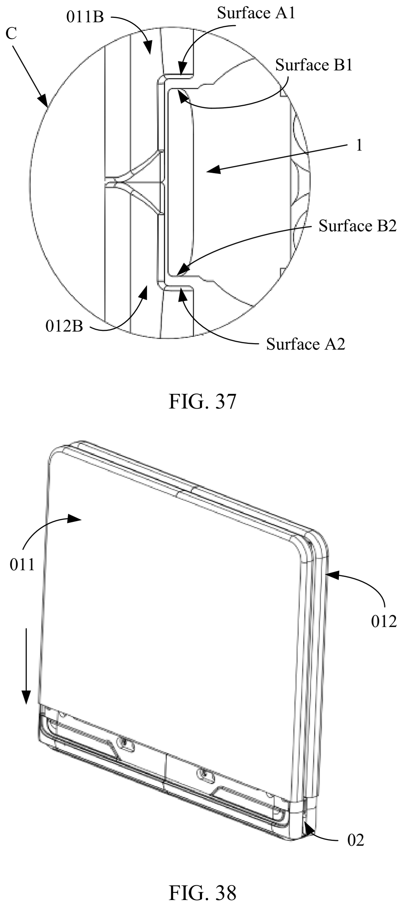

Refer to FIG. 36 and FIG. 37. FIG. 37 is an enlarged view of C in FIG. 36. When the foldable electronic device 100 is in the unfolded state, the surface A1 faces the surface B1, and there is a gap between the surface A1 and the surface B1; and the surface A2 faces the surface B2, and there is a gap between the surface A2 and the surface B2.

In some examples, when the display is in the unfolded state, the gap between the surface A1 and the surface B1 is less than a gap between the first middle frame 011 and the second middle frame 012, and the gap between the surface A2 and the surface B2 is less than the gap between the first middle frame 011 and the second middle frame 012.

In this way, when the foldable electronic device 100 in the unfolded state drops along a direction (a direction of a black arrow) from the first middle frame 011 to the second middle frame 012 shown in FIG. 33, the surface A1 of the first side frame 011B and the surface B1 of the blocking member 1 may abut against each other for support, and the surface A2 of the second side frame 012B and the surface B2 of the blocking member 1 may abut against each other for support. In this way, large compressive force generated when the first middle frame 011 and the second middle frame 012 abut against each other is reduced, and an internal structure of the entire device is protected from further compression-induced impact.

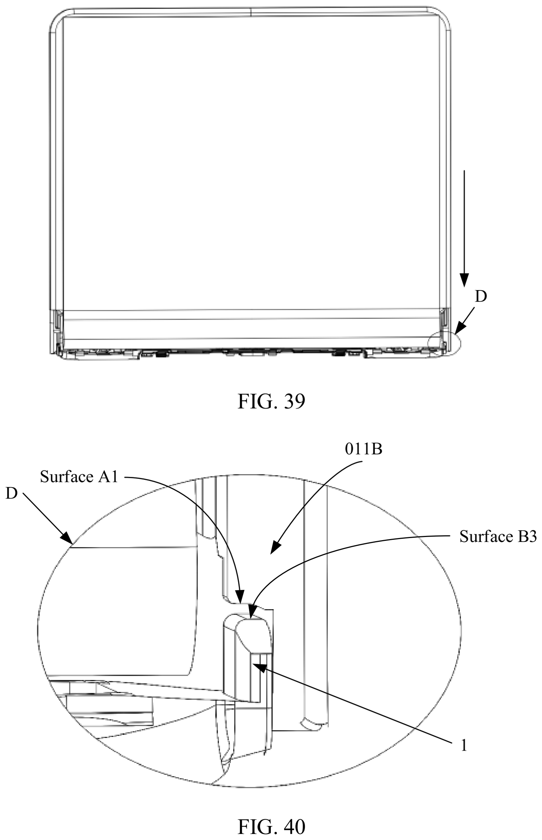

In some scenarios, the foldable electronic device may drop in a manner shown in FIG. 38. To be specific, when the foldable electronic device is in the folded state, the hinge structure 02 faces the ground. To avoid damage to the display or another internal component in the drop scenario, reference is made to FIG. 39 and FIG. 40. FIG. 40 is a diagram of a structure of the foldable electronic device in the folded state. FIG. 40 is an enlarged view of D in FIG. 39. FIG. 40 shows a position relationship between the first side frame 011B of the first middle frame 011 and the blocking member 1. When the foldable electronic device is in the folded state, the surface A1 of the first side frame 011B faces the surface B3 of the blocking member 1, and there is a gap between the surface A1 and the surface B3; and the surface A2 of the second side frame 012B faces the surface B3 of the blocking member 1, and there is a gap (not shown in the figure) between the surface A2 and the surface B3.

As shown in FIG. 40, an orthographic projection of the surface A1 on the surface B3 at least partially overlaps the surface B3. In addition, with reference to FIG. 40, an orthographic projection of the surface A2 on the surface B3 at least partially overlaps the surface B3. In this way, when the foldable electronic device drops to the ground in the scenarios shown in FIG. 38 and FIG. 39 (as shown by black arrows), the surface B3 of the blocking member 1 and each of the surface A1 and the surface A2 may abut against each other for support, so that drop amounts of the first middle frame 011 and the second middle frame 012 are reduced, it is ensured that accommodating space in which the display 03 is located is not compressed, thereby protecting the display, and the internal structure of the entire device is not subjected to compression-induced impact.

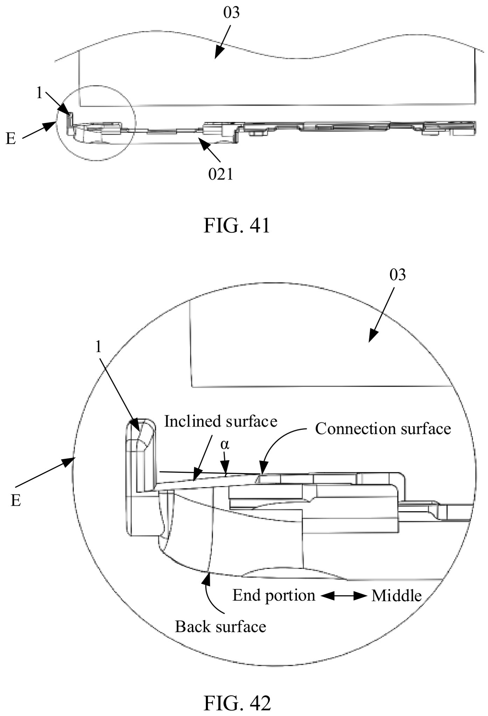

FIG. 41 is a diagram of an exploded structure of the main shaft 021, the blocking member 1, and the display 03 in an example of this application. FIG. 42 is an enlarged view of E in FIG. 41. The main shaft 021 is located on a side of a non-display surface of the display 03. The main shaft 021 includes a first surface facing the non-display surface of the display 03 and a second surface facing away from the first surface. The non-display surface of the display is a surface facing away from a display surface. A region that is of the first surface and that is close to the blocking member is an inclined surface, the inclined surface is inclined toward the second surface in a direction from a middle to the end portion of the main shaft, and there is a gap between the inclined surface and the non-display surface of the display. In a direction from the display to the main shaft, a projection of the display on the first surface is at least partially located on the inclined surface.

Alternatively, in some examples, it may be understood as follows: As shown in FIG. 41, a surface that is of the main shaft 021 and that is used to connect to the blocking member 1 may be referred to as a connection surface, the connection surface faces the non-display surface of the display, and a surface that is of the main shaft 021 and that faces away from the connection surface may be referred to as a back surface. A region that is of the connection surface and that is close to the blocking member 1 is an inclined surface, and the inclined surface is inclined toward the back surface in a direction from a middle to the end portion of the main shaft 201.

The display 03 is in the unfolded state or the folded state, the inclined surface faces the display 03, there is a gap between the inclined surface and the display, and the gap is used to accommodate the display 03 that is offset toward the inclined surface.

It may also be understood that in the direction from the middle to the end portion of the main shaft 201, the gap between the display 03 and the main shaft 021 increases.

When the foldable electronic device in the unfolded state or the folded state drops to the ground along the direction of the black arrow shown in FIG. 39, the display 03 may be offset toward the main shaft 021. Because the end portion of the main shaft 021 is designed with an inclined surface, there is a large distance between the main shaft 021 and a part that is of the display 03 and that is close to the blocking member 1. In this way, a large drop buffer space can be provided for the display 03 that drops, a degree of compression-induced impact between the display 03 that drops and the main shaft 021 is reduced, and a risk of a display failure due to compression is alleviated, so that the display is protected.

In some examples, as shown in FIG. 42, an inclination angle α of the inclined surface on the main shaft 021 may be 3° to 45°. For example, α=10°, or α=20°.

In some implementable structures, the inclined surface shown in FIG. 42 may be a flat surface.

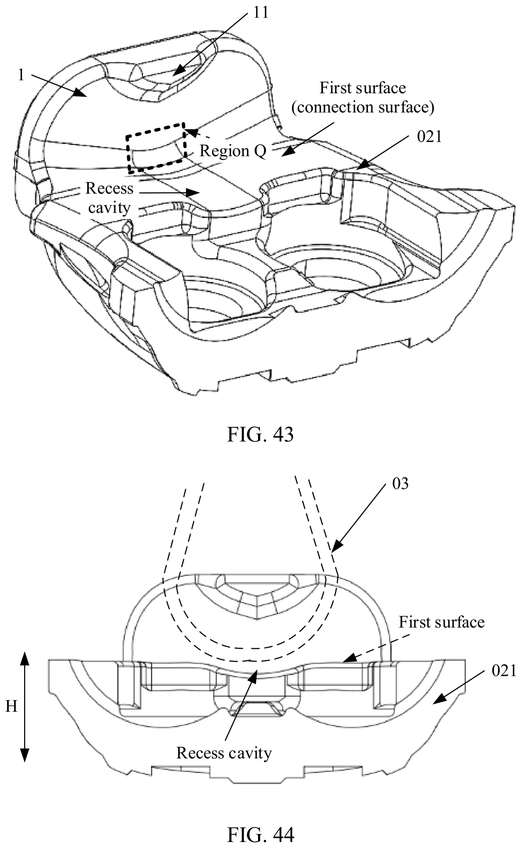

To increase the drop buffer space of the display and improve drop reliability of the display, this application further provides an implementable structure. As shown in FIG. 43, in this example, in the first surface (or referred to as the connection surface connected to the blocking member 1) that is of the main shaft 021 and that faces the non-display surface of the display 03, there is a recess cavity in a region close to the blocking member and at a position close to the middle of the blocking member 1. There is a gap between the non-display surface of the display and a bottom surface of the recess cavity.

For example, as shown in FIG. 44, the display 03 is in the folded state, and the display 03 includes a bent part facing the blocking member. Along a thickness direction of the main shaft (a direction H in FIG. 44), a projection of the bent part on the first surface is at least partially located in the recess cavity.

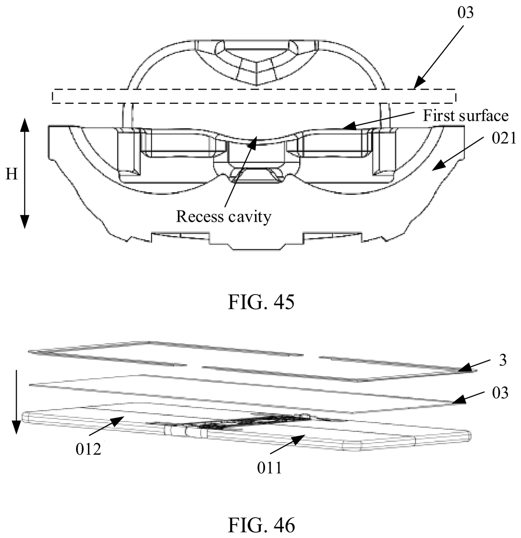

For another example, as shown in FIG. 45, the display 03 is in the unfolded state, and the display includes a flattened part facing the blocking member. Along a thickness direction of the main shaft (a direction H in FIG. 45), a projection of the flattened part on the first surface is at least partially located in the recess cavity.

As shown in FIG. 44 and FIG. 45, when the display is in the folded state or the unfolded state, the recess cavity may provide more accommodating space for the display. For example, when the main shaft drops toward the ground, the recess cavity may provide drop space for the display, to protect the display and reduce a risk of impact between the display and the main shaft.

The thickness direction of the main shaft in this example of this application, for example, the direction H in FIG. 44 and FIG. 45, may be understood as follows: When the display is in the unfolded state, a direction perpendicular to a surface on which the display is located is the thickness direction of the main shaft.

Return to FIG. 43. In this example, from the edge to the middle of the blocking member, a thickness of a bottom part of the blocking member 1 may change from thick to thin. The bottom of the blocking member 1 has a region (for example, a region Q in FIG. 43) with a smallest thickness (the size between the first side surface and the second side surface), and a position of the recess cavity may correspond to a position of the region Q with the smallest thickness.

Alternatively, in some examples, as shown in FIG. 43, there is a protruding block 11 protruding toward the display on the first side surface of the blocking member 1 and at a position close to the middle of the top of the blocking member 1.

As shown in FIG. 43, the protruding block on the blocking member 1 may be disposed opposite to the region Q with the smallest thickness. A position of the recess cavity may correspond to a position of the region Q with the smallest thickness.

In some implementable processes, the structure of the blocking member 1 shown in FIG. 43 may be integrally formed by using an injection molding process.

FIG. 46 is an exploded diagram of the foldable electronic device 100 in an example of this application. In addition to the first middle frame 011, the second middle frame 012, the display 03, and the hinge structure, the foldable electronic device may further include a decorative frame 3. The decorative frame 3 is disposed on an outer edge of the first middle frame 011 and the second middle frame 012, and an edge of the display 03 is fastened between the middle frame and the decorative frame 3.

When the foldable electronic device in the unfolded state drops along a direction of a black arrow shown in FIG. 46, that is, when the first middle frame 011 and the second middle frame 012 face the ground, the unfolded display 03 may bulge upward. In some scenarios, the bulged display 03 may impact the decorative frame 3, and consequently the display 03 may fail.

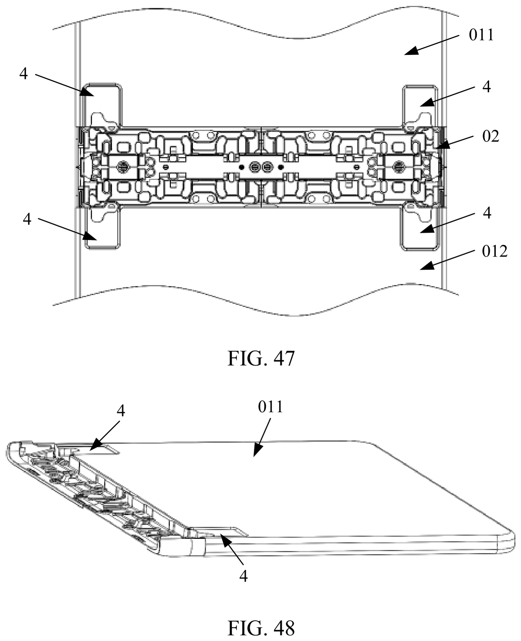

To avoid compression between the bulged display 03 and the decorative frame 3 or between the display 03 and the middle frame, as shown in FIG. 47 and FIG. 48, a groove 4 may be provided on at least one of the first middle frame 011 and the second middle frame 012 and at a position close to the hinge structure 02. A projection of the display 03 on the first middle frame is partially located in a groove 4 of the first middle frame, a projection of the display 03 on the second middle frame is partially located in a groove 4 of the second middle frame, and the groove 4 is used to accommodate the deformed display 03.

Along a thickness direction of the middle frame, in some examples, the groove 4 may not pass through the middle frame; in some other examples, the groove 4 may pass through the middle frame.

In the examples of FIG. 47 and FIG. 48, surface lowering is partially performed on positions that are of the first middle frame 011 and the second middle frame 012 and that are close to the hinge structure 02, to increase a Z-direction space (space along a thickness direction of the electronic device), so that a bulged part of the display can be redundantly located in the groove 4 of the middle frame, thereby greatly reducing a risk of a failure caused by impact between the display and the decorative frame.

When the foldable electronic device drops along the direction in FIG. 46, compared with another part, a part that is of the display 03 and that is close to an end portion of the hinge structure 02 has a large amount of bulging deformation. Further, as shown in FIG. 47 and FIG. 48, the groove 4 provided on the middle frame is provided close to the end portion of the hinge structure 02.

In the descriptions of this specification, specific features, structures, materials, or characteristics may be combined in an appropriate manner in any one or more of embodiments or examples.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A foldable electronic device, comprising:
a first middle frame and a second middle frame;
a hinge structure, wherein the first middle frame and the second middle frame are disposed on two sides of the hinge structure; and
a display, disposed on one side of the hinge structure, wherein the first middle frame and the second middle frame move toward or away from each other through the hinge structure, so that the display is switched between an unfolded state and a folded state, wherein
an end portion of the hinge structure comprises a blocking member, and along an axial direction of the hinge structure, the blocking member comprises a first side surface and a second side surface that face away from each other, wherein the first side surface faces a side surface of the display; and
a partial region on the first side surface has an avoidance space, and along the axial direction of the hinge structure, a projection of the display on the first side surface is at least partially located in the avoidance space.

2. The foldable electronic device according to claim 1, wherein
the first side surface of the blocking member has a recess portion that is recessed toward the second side surface, and the avoidance space is located in the recess portion.

3. The foldable electronic device according to claim 2, wherein
the display comprises a first part facing the blocking member, and along the axial direction of the hinge structure, a projection of the first part on the first side surface is at least partially located in the recess portion.

4. The foldable electronic device according to claim 3, wherein
the display is in the folded state, the first part is in a bent state, and along the axial direction of the hinge structure, a projection of the bent part on the first side surface is at least partially located in the recess portion; or
the display is in the unfolded state, the first part is in a flattened state, and along the axial direction of the hinge structure, a projection of the flattened part on the first side surface is at least partially located in the recess portion.

5. The foldable electronic device according to any one of claims 2 to 4, wherein
along a first direction, in a direction from an edge to a middle of the blocking member, a part that is on the first side surface of the blocking member and that is close to a bottom of the blocking member is inclined toward the second side surface; and
the first direction is a direction from the hinge structure to the first middle frame when the display is in the unfolded state.

6. The foldable electronic device according to any one of claims 2 to 5, wherein
a protruding block protruding toward the display is disposed on the first side surface of the blocking member and at a position close to a middle of a top of the blocking member, there is a distance between the protruding block and the bottom of the blocking member, and a part that is of the first side surface and that is recessed relative to the protruding block forms the recess portion.

7. The foldable electronic device according to claim 6, wherein
the recess portion comprises a first region located on one side of the protruding block, a second region located on the other side of the protruding block, and a third region located between the protruding block and the bottom of the blocking member;
the display is in the folded state, and the display comprises a first curved segment, a second curved segment, and a middle curved segment connected between the first curved segment and the second curved segment;
the first region faces the first curved segment, and along the axial direction of the hinge structure, a projection of the first curved segment on the first side surface is at least partially located in the first region;
the second region faces the second curved segment, and along the axial direction of the hinge structure, a projection of the second curved segment on the first side surface is at least partially located in the second region; and
the third region faces the middle curved segment, and along the axial direction of the hinge structure, a projection of the middle curved segment on the first side surface is at least partially located in the third region.

8. The foldable electronic device according to claim 6 or 7, wherein
the display is in the unfolded state, the recess portion located below the protruding block faces at least a part of the side surface of the display, and along the axial direction of the hinge structure, the projection of the display on the first side surface is at least partially located in the recess portion below the protruding block.

9. The foldable electronic device according to any one of claims 6 to 8, wherein
the display is in the unfolded state or the folded state, and there is a gap between the side surface of the display and a side surface that is of the protruding block and that faces the display.

10. The foldable electronic device according to any one of claims 2 to 4, wherein
the first side surface of the blocking member has a protruding block disposed around an edge, and the protruding block disposed around the edge surrounds the recess portion.

11. The foldable electronic device according to claim 10, wherein
the display is in the folded state, and the display comprises a first curved segment, a second curved segment, and a middle curved segment connected between the first curved segment and the second curved segment; and
along the axial direction of the hinge structure, projections of the first curved segment, the second curved segment, and the middle curved segment on the first side surface are at least partially located in the recess portion.

12. The foldable electronic device according to any one of claims 2 to 11, wherein an elastic structure is disposed in the recess portion.

13. The foldable electronic device according to any one of claims 1 to 12, wherein along the first direction, in a direction from the middle to the edge of the blocking member, the first side surface is inclined toward the second side surface; and
the first direction is the direction from the hinge structure to the first middle frame when the display is in the unfolded state.

14. The foldable electronic device according to any one of claims 1 to 13, wherein
the hinge structure comprises a main shaft, the main shaft is located on a side of a non-display surface of the display, an end portion of the main shaft comprises the blocking member, the main shaft comprises a first surface facing the non-display surface of the display and a second surface facing away from the first surface, and the non-display surface of the display is a surface facing away from a display surface.

15. The foldable electronic device according to claim 14, wherein
a region that is of the first surface and that is close to the blocking member is an inclined surface, the inclined surface is inclined toward the second surface in a direction from a middle to the end portion of the main shaft, and there is a gap between the inclined surface and the non-display surface of the display; and
in a direction from the display to the main shaft, a projection of the display on the first surface is at least partially located on the inclined surface.

16. The foldable electronic device according to claim 14 or 15, wherein a recess cavity is provided in the region that is of the first surface and that is close to the blocking member and at a position close to the middle of the blocking member, and there is a gap between the non-display surface of the display and a bottom surface of the recess cavity.

17. The foldable electronic device according to claim 16, wherein
the display is in the folded state, the display comprises the bent part facing the blocking member, and along a thickness direction of the main shaft, a projection of the bent part on the first surface is at least partially located in the recess cavity; or
the display is in the unfolded state, the display comprises the flattened part facing the blocking member, and along a thickness direction of the main shaft, a projection of the flattened part on the first surface is at least partially located in the recess cavity.

18. The foldable electronic device according to any one of claims 1 to 17, wherein a groove is provided on at least one of the first middle frame and the second middle frame and at a position close to the hinge structure, and in a direction from the display to the first middle frame, a projection of the display on the first middle frame is at least partially located in the groove.

19. The foldable electronic device according to claim 18, wherein the groove is provided close to the end portion of the hinge structure.

20. The foldable electronic device according to any one of claims 1 to 19, wherein a first groove is provided at an edge of the first middle frame, and a second groove is provided at an edge of the second middle frame;
the blocking member is disposed in a space enclosed by the first groove and the second groove;
the edge of the first middle frame has a first surface enclosing the first groove, and the edge of the second middle frame has a second surface enclosing the second groove; and
the display is in the folded state, the first surface faces a top surface of the blocking member, there is a gap between the first surface and the top surface of the blocking member, the second surface faces the top surface of the blocking member, and there is a gap between the second surface and the top surface of the blocking member.
